# FASCICULE DE BREVET EUROPEEN

(11) **EP 3 731 414 B1**
(45) Date de publication et mention de la délivrance du brevet: **15.03.2023**
(21) Numéro de dépôt: 20171008.4
(22) Date de dépôt: 23.04.2020
(51) Int. Cl.: H03K 19/003, H03K 19/0185, H03K 17/30

(54) **CIRCUIT D'ENTRÉE-SORTIE COMPORTANT UN CIRCUIT DE PROTECTION COMPRENANT DES TRANSISTORS EN SÉRIE, ET PROCÉDÉ DE COMMANDE D'UN TEL CIRCUIT**
EINGANGS-AUSGANGSSCHALTUNG UMFASSEND EINE SCHUTZSCHALTUNG MIT EINER REIHENSCHALTUNG VON TRANSISTOREN, UND VERFAHREN ZUM STEUERN DER SCHALTUNG
INPUT/OUTPUT CIRCUIT COMPRISING A PROTECTION CIRCUIT HAVING TRANSISTORS IN SERIES, AND METHOD FOR CONTROLLING SAID CIRCUIT

(30) Priorité: 26.04.2019 FR 1904484
(43) Date de publication de la demande: 28.10.2020
(73) Titulaire: STMicroelectronics (Rousset) SAS, 13790 Rousset (FR)
(72) Inventeur: FROIDEVAUX, Nicolas, 13100 Aix-en-Provence (FR); LOPEZ, Laurent, 13790 Peynier (FR)
(74) Mandataire: Cabinet Beaumont

(56) Documents cités:
- US-A- 5 118 968
- US-A- 5 723 990
- US-A1- 2019 007 031

## Description

### Domaine technique

La présente description concerne de façon générale les dispositifs électroniques et, plus particulièrement, les puces intégrant un ou plusieurs circuits d'entrée-sortie comportant des plots de connexion.

### Technique antérieure

On connaît des circuits d'entrée-sortie, intégrés à une puce, qui comportent des plots de connexion dits « non tolérants ». Ces plots non tolérants disposent typiquement de moyens de protection contre d'éventuelles injections de courant. Les injections de courant via des plots de connexion peuvent, dans certains cas, produire des effets néfastes pour la puce. On cherche donc à se prémunir de ces injections de courant, généralement en utilisant des diodes. Un des inconvénients liés à l'utilisation de ces diodes provient du fait que cela restreint une plage de tensions d'entrée admissibles par le circuit. Cette restriction s'avère parfois préjudiciable à certaines applications, pour lesquelles une plus grande plage de tensions est souhaitable.

On connaît, en outre, des circuits d'entrée-sortie comportant des plots de connexion dits « tolérants ». Ces circuits dotés de plots tolérants permettent, par rapport aux circuits dotés de plots non tolérants, d'élargir la plage de tensions d'entrée admissibles sans risquer de dégrader la puce ainsi que le signal appliqué sur le plot. Il est notamment possible, pour des applications spécifiques, de porter ces plots tolérants à des potentiels électriques sensiblement supérieurs à un potentiel d'alimentation de la puce. Les plots non tolérants ne sont toutefois, pour certaines applications, pas remplaçables par des plots tolérants.

Actuellement, on décide avant de fabriquer la puce quel sera le type de plot (plot tolérant ou plot non tolérant) de chaque circuit d'entrée-sortie. Cette décision est, la plupart du temps, conditionnée par les applications visées. Dès lors que la puce a été fabriquée, le type de plot de chaque circuit d'entrée-sortie n'est plus modifiable. Cela confère donc, aux circuits d'entrée-sortie existants, une faible flexibilité.

Le document US 2019/007031 décrit un dispositif semiconducteur à mécanisme de déclenchement de puissance.

Le document US 5723990 décrit un circuit intégré comportant un circuit de détection de surtension.

Le document US 5118968 décrit un circuit d'activation de mode spécial.

### Résumé de l'invention

Il existe un besoin d'améliorer la flexibilité des circuits d'entrée-sortie existants.

L'invention est définie selon les revendications indépendantes.

Un mode de réalisation pallie tout ou partie des inconvénients des circuits d'entrée-sortie connus.

Un mode de réalisation prévoit un dispositif comportant, en série :
un premier transistor MOS de type P ;
un deuxième transistor MOS de type N, connecté au premier transistor ; et
un troisième transistor MOS de type N, connecté au deuxième transistor, ledit troisième transistor étant commandé par un signal numérique,
dans lequel la grille du premier transistor et la grille du deuxième transistor sont interconnectées et destinées à recevoir un potentiel d'alimentation d'une puce.

Selon un mode de réalisation :
le drain du deuxième transistor est connecté au drain du premier transistor ; et
la source du deuxième transistor est connectée au drain du troisième transistor.

Selon un mode de réalisation, un potentiel de référence est appliqué sur la source du troisième transistor.

Selon un mode de réalisation, le potentiel d'alimentation correspond à une tension continue appliquée entre les grilles communes des premier et deuxième transistors et la source du troisième transistor.

Selon un mode de réalisation, le signal numérique est adapté à commander, en tout ou rien, le passage d'un courant dans l'association en série.

Selon un mode de réalisation, l'association en série forme, en fonction de l'état du signal numérique commandant le troisième transistor, tantôt une diode et tantôt un circuit ouvert.

Selon un mode de réalisation, ledit dispositif comporte exclusivement trois transistors.

Un mode de réalisation prévoit une puce électronique comportant au moins un dispositif tel que décrit.

Selon un mode de réalisation, la source du premier transistor dudit dispositif est reliée à au moins un plot de connexion de la puce.

Selon un mode de réalisation, la tension d'alimentation de la puce est appliquée entre les grilles communes des premier et deuxième transistors et la source du troisième transistor.

Un mode de réalisation prévoit un procédé de commande d'un dispositif tel que décrit, dans lequel :
le signal numérique de commande est placé dans un premier état pour conférer une fonction de diode ; et
le signal numérique de commande est placé dans un deuxième état pour forcer un circuit ouvert.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon schématique, un exemple de puce électronique ;
la figure 2 représente, de façon schématique, un exemple de circuit d'entrée-sortie d'une puce électronique , pas couvert par l'invention ;
la figure 3 représente, de façon schématique, un autre exemple de circuit d'entrée-sortie d'une puce électronique , pas couvert par l'invention ;
la figure 4 représente, de façon schématique, un mode de réalisation d'un circuit d'entrée-sortie d'une puce électronique ; et
la figure 5 représente, de façon schématique, un mode de réalisation d'une diode commutable par un signal numérique.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la génération des signaux à transmettre par les circuits d'entrée-sortie et le traitement de ces signaux ne sont pas détaillés, les modes de réalisation décrits étant compatibles avec les applications usuelles des circuits d'entrée-sortie.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

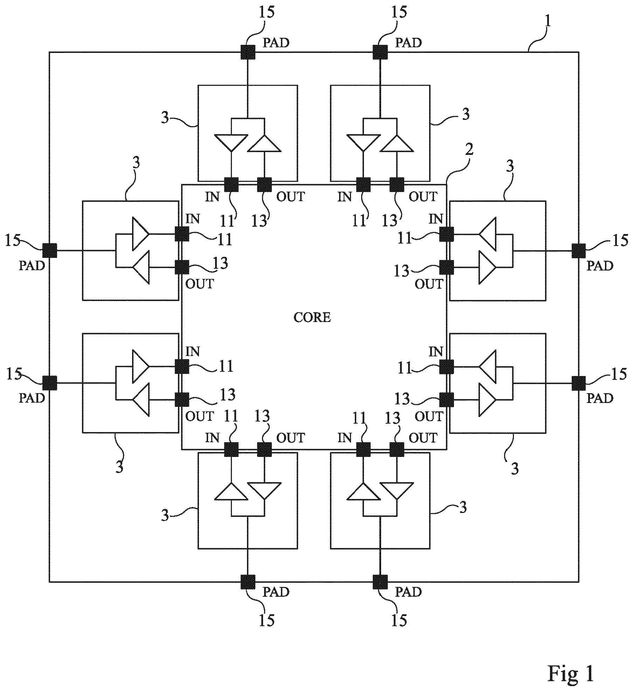

La figure 1 représente, de façon schématique, un exemple de puce électronique 1.

Dans l'exemple de la figure 1, la puce électronique 1 comporte des circuits 3 ou cellules d'entrée-sortie. Les circuits 3 d'entrée-sortie permettent au coeur 2 (CORE) de la puce 1 de communiquer avec l'extérieur. Chaque circuit 3 d'entrée-sortie est, toujours dans l'exemple de la figure 1, connecté à :
une borne 11 (IN) d'entrée du coeur 2 de la puce 1 ;
une borne 13 (OUT) de sortie du coeur 2 de la puce 1 ; et
un plot 15 (PAD) permettant, par exemple, de connecter la puce 1 à des éléments de reprise de contact (non représentés) situés en surface d'une carte électronique (non représentée).

Les circuits 3 d'entrée-sortie forment typiquement un anneau d'entrée-sortie (I/O ring). Ces circuits 3 d'entréesortie permettent par exemple au coeur 2 de la puce 1 d'échanger des signaux numériques avec l'extérieur. Les circuits 3 d'entrée-sortie assurent généralement une fonction de protection contre des décharges électrostatiques susceptibles d'endommager le coeur 2 de la puce 1.

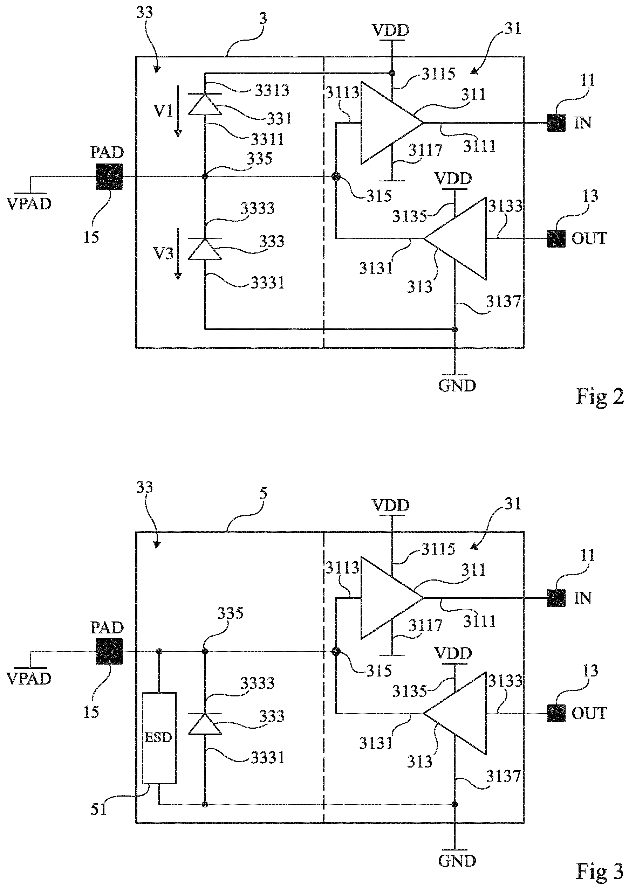

La figure 2 représente, de façon schématique, un exemple de circuit 3 d'entrée-sortie d'une puce électronique.

Dans l'exemple de la figure 2, le circuit 3 d'entréesortie (par exemple, l'un des circuits 3 d'entrée-sortie de la puce 1 comme exposé en figure 1) se compose :
d'un circuit 31 de mise à niveau, comportant notamment deux amplificateurs ou circuits tampons (buffers) 311 et 313 ; et
d'un circuit 33 de protection, comportant notamment deux diodes 331 et 333.

On désignera par la suite les circuits tampons 311 et 313 comme étant des amplificateurs, sachant qu'ils n'amplifient pas nécessairement le signal numérique appliqué sur leur entrée. Leur fonction première est de porter les niveaux haut et bas d'entrée aux potentiels respectifs d'alimentation du circuit 311, 313 concerné (dans l'exemple, le potentiel VDD et la masse GND), aux chutes de tension près dans le ou les transistors constituant le circuit 311, 313 à l'état passant.

Une sortie 3111 de l'amplificateur 311 du circuit 31 de mise à niveau est, en figure 2, connectée à la borne 11 (IN) d'entrée du coeur 2 (figure 1) de la puce 1. Une entrée 3133 de l'amplificateur 313 est connectée à la borne 13 (OUT) de sortie du coeur 2 (figure 1) de la puce 1. Une sortie 3131 de l'amplificateur 313 et une entrée 3113 de l'amplificateur 311 sont connectées entre elles, dans cet exemple par l'intermédiaire d'un noeud 315 de connexion commun. Ce noeud 315 de connexion est connecté au plot 15 (PAD) de connexion de la puce 1.

Une broche 3115 d'alimentation positive de l'amplificateur 311 et une broche 3135 d'alimentation positive de l'amplificateur 313 sont, en figure 2, toutes deux portées à un même potentiel électrique VDD. Ce potentiel VDD correspond généralement à une tension d'alimentation de la puce 1, issue d'une source d'alimentation (non représentée) La tension VDD est typiquement comprise entre 1,8 V et 3,6 V. Une broche 3117 d'alimentation négative de l'amplificateur 311 est portée à un potentiel électrique quelconque (non représenté). Une broche 3137 d'alimentation négative de l'amplificateur 313 est portée à un potentiel de référence (typiquement la masse, GND).

Dans l'exemple de la figure 2, une anode 3311 de la diode 331 du circuit 33 de protection est connectée au plot 15 de connexion de la puce 1. Une cathode 3313 de la diode 331 est connectée à la broche 3115 d'alimentation positive de l'amplificateur 311 du circuit 31 de mise à niveau. Une anode 3331 de la diode 333 est connectée à la broche 3137 d'alimentation négative de l'amplificateur 313 du circuit 31 de mise à niveau. Une cathode 3333 de la diode 333 est connectée au plot 15 de connexion de la puce 1. La cathode 3313 de la diode 331 est ainsi portée au potentiel VDD tandis que l'anode 3331 de la diode 333 est mise à la masse GND. On suppose par la suite, pour simplifier, que le potentiel de la masse GND est nul (GND = 0 V). Le potentiel GND constitue ainsi une référence de potentiel pour le circuit 1.

L'anode 3311 de la diode 331 et la cathode 3333 de la diode 333 du circuit 33 de protection de la puce 1 sont, en figure 2, toutes deux connectées en un autre noeud 335 de connexion. Le plot 15, les noeuds 315 et 335 de connexion, l'anode 3311 de la diode 331, la cathode 3333 de la diode 333, l'entrée 3113 de l'amplificateur 311 et la sortie 3131 de l'amplificateur 313 sont ainsi (aux chutes de tensions parasites près dans les conducteurs) au potentiel du plot PAD, noté VPAD.

Les diodes 331 et 333 du circuit 33 de protection sont passantes, c'est-à-dire laissent passer un courant électrique, lorsqu'elles sont polarisées par une tension supérieure à une tension de seuil, notée VSEUIL. On suppose par la suite, pour simplifier, que les diodes 331 et 333 sont toutes deux caractérisées par une tension de seuil VSEUIL identique. Cette tension de seuil VSEUIL est typiquement de l'ordre de 0,7 V pour une diode au silicium (jonction PN).

On fait abstraction, pour simplifier, de phénomènes d'avalanche pouvant se produire dans les diodes 331 et 333 en cas d'application d'une forte tension inverse. On considère ainsi que la diode 331 n'est passante que si une tension V1 au moins égale à la tension VSEUIL est appliquée entre son anode 3311 et sa cathode 3313. On considère sinon (si la tension V1 est strictement inférieure à la tension VSEUIL) que la diode 331 est bloquée, c'est-à-dire qu'elle ne laisse passer aucun courant. Dans l'exemple de la figure 2, la tension V1 est égale à VPAD - VDD.

De même, on considère que la diode 333 n'est passante que si une tension V3, au moins égale à la tension VSEUIL, est appliquée entre son anode 3331 et sa cathode 3333. On considère sinon (si la tension V3 est strictement inférieure à la tension VSEUIL) que la diode 333 est bloquée, c'est-à-dire qu'elle ne laisse passer aucun courant. Dans l'exemple de la figure 2, la tension V3 est égale à -VPAD.

Trois cas de fonctionnement sont ainsi théoriquement possibles, en fonction de la valeur de la tension VPAD, pour le circuit 3 d'entrée-sortie :
dans un premier cas, si la tension VPAD est strictement comprise entre -VSEUIL et VDD + VSEUIL, les diodes 331 et 333 sont bloquées (car les tensions V1 et V3 sont alors toutes deux strictement inférieures à la tension VSEUIL) ;
dans un deuxième cas, si la tension VPAD est inférieure ou égale à -VSEUIL, la diode 333 est passante (car la tension V3 est alors supérieure ou égale à la tension VSEUIL) tandis que la diode 331 est bloquée (car la tension V1 est alors strictement inférieure à la tension VSEUIL) ; et
dans un troisième cas, si la tension VPAD est supérieure ou égale à VDD + VSEUIL, la diode 331 est passante (car la tension V1 est alors supérieure ou égale à la tension VSEUIL) tandis que la diode 333 est bloquée (car la tension V3 est alors strictement inférieure à la tension VSEUIL).

Le premier cas de fonctionnement correspond à une situation normale. Dans cette situation, le circuit 3 d'entrée-sortie de la puce 1 admet, sur son plot 15, une plage de tensions VPAD comprises entre -VSEUIL et VDD + VSEUIL. Le plot 15 du circuit 3 est alors qualifié de « plot non tolérant ».

Le deuxième cas correspond typiquement à une situation anormale due à une injection négative, ou surtension négative, sur le plot 15. La diode 333 étant passante dans ce cas, un courant peut alors circuler depuis la masse GND vers le plot 15 ce qui permet de protéger le circuit 31 de mise à niveau contre la surtension négative.

Le troisième cas correspond typiquement à une autre situation anormale due à une injection positive, ou surtension positive, sur le plot 15. La diode 331 étant passante dans ce cas, un courant peut alors circuler depuis le plot 15 vers une source d'alimentation de la puce 1 ce qui permet de protéger le circuit 31 de mise à niveau contre la surtension positive.

Les diodes 331 et 333 du circuit de protection 33 permettent ainsi de protéger le circuit 31 de mise à niveau du circuit 3 d'entrée-sortie contre d'éventuelles surtensions, positives ou négatives. La diode 331 constitue une voie d'injection vers l'alimentation VDD. La diode 333 constitue une voie d'extraction depuis la masse GND.

Un inconvénient lié à la mise en oeuvre des diodes 331 et 333 réside dans le fait que l'on est contraint, en fonctionnement normal, à ne pas dépasser, sur le plot 15 de la puce 1, une tension VPAD environ égale à VDD + VSEUIL. Cette contrainte peut empêcher d'utiliser la puce 1 pour des applications où l'on a besoin d'appliquer une tension VPAD sensiblement supérieure à VDD + VSEUIL.

La figure 3 représente, de façon schématique, un autre exemple de circuit 5 d'entrée-sortie d'une puce électronique.

Le circuit 5 d'entrée-sortie de la figure 3 est, par exemple, un autre circuit d'entrée-sortie de la puce 1. Ce circuit 5 d'entrée-sortie comprend des éléments communs avec le circuit 3 d'entrée-sortie de la figure 2. Ces éléments communs ne seront pas détaillés à nouveau ci-après.

Le circuit 5 d'entrée-sortie de la figure 3 diffère du circuit 3 d'entrée-sortie de la figure 2 principalement en ce que le circuit 5 ne comporte pas de diode 331. Il n'y a donc pas, dans le circuit 5 d'entrée-sortie, de voie d'injection possible vers l'alimentation VDD.

L'absence de la diode 331 (figure 2) permet au circuit 5 d'entrée-sortie de la figure 3 d'accepter, sur son plot 15, une plage de tensions élargie par rapport à la plage de tensions admissibles du circuit 3. Cela permet, par exemple, à une puce 1 d'utiliser un même plot 15 pour véhiculer divers types de signaux en fonction d'une ou de plusieurs applications. Il est alors notamment possible d'appliquer, sur le plot 15 du circuit 5, une tension VPAD sensiblement supérieure à VDD. Cette opération est aussi possible car la conception des amplificateurs 331 et 333 permet de supporter des tensions supérieures à la tension VDD sur le plot 15 sans risque de dégradation des composants et sans déclenchement de courant de fuite excessif qui pourrait altérer l'intégrité du signal appliqué sur le plot 15. Pour une tension d'alimentation VDD de l'ordre de 3 V, on peut ainsi typiquement imposer, sur le plot 15, une tension VPAD de l'ordre de 5 V. Le plot 15 du circuit 5 est qualifié de « plot tolérant ».

Le circuit 33 de protection comporte, en figure 3, un composant 51 (ESD) additionnel permettant de protéger le circuit 31 de mise à niveau contre d'éventuelles décharges électrostatiques. Ce composant 51 est, dans cet exemple, connecté en parallèle de la diode 333.

Toutefois, la puce 1 n'est alors pas protégée contre des tensions positives durables et l'application (connectée au plot 15) doit veiller à ne pas imposer de tension positive supérieure à ce que peuvent supporter les composants de la puce 1. La protection ESD du composant 51 ne protège, en effet, que contre des surtensions transitoires.

Le circuit 5 d'entrée-sortie de la puce 1 ne permet toutefois pas de répondre à des applications pour lesquelles on a besoin de la diode 331 (figure 2). En d'autres termes, les circuits 3 (figure 2) et 5 présentent chacun des avantages différents, inhérents à la présence ou à l'absence de la diode 331 (figure 2).

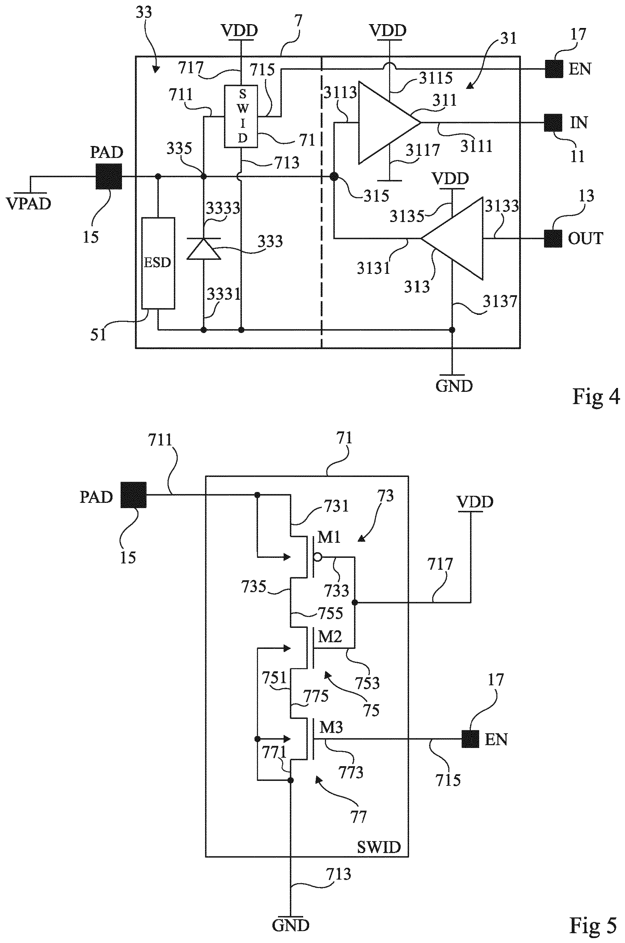

La figure 4 représente, de façon schématique, un mode de réalisation d'un circuit 7 d'entrée-sortie d'une puce électronique.

Selon ce mode de réalisation, le circuit 7 d'entréesortie de la figure 4 est, par exemple, encore un autre circuit d'entrée-sortie de la puce 1. Ce circuit 7 d'entréesortie comprend des éléments communs avec le circuit 5 d'entrée-sortie de la figure 3. Ces éléments communs ne seront pas détaillés à nouveau ci-après.

Le circuit 7 d'entrée-sortie de la figure 4 diffère du circuit 5 d'entrée-sortie de la figure 3 principalement en ce que le circuit 7 comporte un composant 71 (SWID), ou diode commutable, et une borne 17 (EN) additionnels. La diode commutable 71 est, en figure 4, connectée :
par une première broche 711 de connexion, au noeud 335 de connexion ;
par une deuxième broche 713 de connexion, à la masse GND ;
par une troisième broche 715 de connexion, à la borne 17 de la puce 1 ; et
par une quatrième broche 717 de connexion, à une source d'alimentation (non représentée) appliquant le potentiel VDD.

La borne 17 est, de préférence, côté coeur de puce (non représenté en figure 4), ce qui permet de ne pas modifier le nombre de plots externes à la puce 1.

On applique un signal numérique (ou signal tout ou rien), noté CMD, sur la borne 17 de la puce 1. Le signal numérique CMD parvient donc à la diode commutable 71 par l'intermédiaire de sa troisième broche 715. Ce signal numérique CMD est adapté à commander la diode commutable 71.

Selon un mode de réalisation préféré, un premier état, de préférence un état haut, du signal CMD de commande permet à la diode commutable 71 de se comporter comme une diode dont :
une anode, correspondant à la première broche 711 de la diode commutable 71, est portée au potentiel VPAD ; et
une cathode, correspondant à la deuxième broche 713 de la diode commutable 71, est portée au potentiel GND.

Lorsque le signal CMD est à l'état haut, tout se passe donc comme si le circuit 7 d'entrée-sortie de la figure 4 comportait une diode entre la borne 15 de la puce 1 et la masse GND. En d'autres termes, le circuit 7 est alors comparable au circuit 3 (figure 2), à l'exception près que la diode commutable 71 du circuit 7 fournit une voie d'injection vers la masse GND tandis que la diode 331 du circuit 3 fournit une voie d'injection vers l'alimentation VDD. Lorsque le signal CMD est à l'état haut, on se ramène donc à un fonctionnement du circuit 7 équivalent à celui du circuit 3 (figure 2), à la différence près qu'une surtension positive (VPAD ≥ VDD + VSEUIL) est évacuée non plus vers l'alimentation VDD, mais vers la masse GND.

Selon ce mode de réalisation préféré, un deuxième état, de préférence un état bas, du signal CMD de commande permet de former, entre la première broche 711 et la deuxième broche 713 de la diode commutable 71, un circuit ouvert.

Lorsque le signal CMD est à l'état bas, le circuit 7 est alors comparable au circuit 5 exposé en relation avec la figure 3. Lorsque le signal CMD est à l'état bas, on se ramène donc à un fonctionnement du circuit 7 semblable à celui du circuit 5 (figure 3).

Suivant l'état du signal CMD appliqué sur la borne 17 de la puce 1, on peut donc, toujours selon ce mode de réalisation préféré, obtenir :
tantôt un plot 15 non tolérant, c'est-à-dire un composant 71 se comportant comme une diode, lorsque le signal CMD est à l'état haut ; et
tantôt un plot 15 tolérant, c'est-à-dire un composant 71 se comportant comme un circuit ouvert, lorsque le signal CMD est à l'état bas.

Par rapport au circuit 3 (figure 2) et au circuit 5 (figure 3), le circuit 7 de la puce 1 présente l'avantage de posséder un plot 15 configurable, en plot tolérant ou en plot non tolérant, en fonction de l'état du signal numérique CMD appliqué sur la borne 17 de la puce 1. Cela confère ainsi une plus grande flexibilité au circuit 7 et, plus généralement, à la puce 1.

La figure 5 représente, de façon schématique, un mode de réalisation d'une diode commutable par un signal numérique.

Selon ce mode de réalisation, une diode commutable, par exemple la diode commutable 71 (SWID) du circuit 7 (figure 4), se compose, de préférence, d'un assemblage en série :
d'un premier transistor 73 (M1) ;
d'un deuxième transistor 75 (M2) ; et
d'un troisième transistor 77 (M3).

Les transistors 73, 75 et 77 de la diode commutable 71 sont, de préférence, des transistors à effet de champ de type MOS. Dans l'exemple de la figure 5, les transistors 75 et 77 de la diode commutable 71 présentent, par rapport au transistor 73, un type de conductivité différent. Le transistor 71 est, de préférence, un transistor MOS de type P ou à canal P (ou MOSFET à canal P, PFET, PMOS, etc.) tandis que les transistors 75 et 77 sont tous deux des transistors MOS de type N ou à canal N (ou MOSFET à canal N, NFET, NMOS, etc.).

Selon un mode de réalisation préféré, le premier transistor 73 est tel que :
une source 731 du premier transistor 73 est connectée à la borne 15 de la puce 1 ;
une grille 733 du premier transistor 73 est portée au potentiel VDD d'alimentation de la puce 1 ; et
un drain 735 du premier transistor 73 est connecté à un drain 755 du deuxième transistor 75.

Le deuxième transistor 75 est, toujours selon ce mode de réalisation préféré, tel que :
une source 751 du deuxième transistor 75 est connectée à un drain 775 du troisième transistor 77 ;
une grille 753 du deuxième transistor 75 est portée au potentiel VDD d'alimentation de la puce 1 ; et
un drain 755 du deuxième transistor 75 est connecté au drain 735 du premier transistor 73.

Le troisième transistor 77 est, toujours selon ce mode de réalisation préféré, tel que :
une source 771 du troisième transistor 77 est mise à la masse GND ;
une grille 773 du troisième transistor 77 est connectée à la borne 17 de la puce 1 ; et
le drain 775 du troisième transistor 77 est connecté à la source 751 du deuxième transistor 75.

En se référant aux notations de la figure 4 :
la source 731 du premier transistor 73 est connectée à la première broche 711 de la diode commutable 71 ;
la grille 733 du premier transistor 73 et la grille 753 du deuxième transistor 75 sont interconnectées pour former la quatrième broche 717 de la diode commutable 71 ;
la grille 773 du troisième transistor 77 est connectée à la troisième broche 715 de la diode commutable 75 ; et
la source 771 du troisième transistor 77 est connectée à la deuxième broche 713 de la diode commutable 71.

Les caissons (bulk) des transistors M2 et M3 sont interconnectés à la source 771 du transistor M3 (masse GND). Le caisson du transistor M1 est connecté à la source 731 du transistor M1 (plot 15).

Une tension continue (VDD), de préférence la tension d'alimentation de la puce 1, est ainsi appliquée entre :
les grilles 733 et 753 communes des premier et deuxième transistors 73 et 75 ; et
la source 771 du troisième transistor 77.

On considère, pour simplifier, que tous les transistors 73, 75 et 77 présentent une même valeur de tension de seuil, notée VTH.

Le premier transistor 73 est théoriquement passant si on applique, entre sa grille 733 et sa source 731, une tension inférieure ou égale à la tension VTH. Le premier transistor 73 est théoriquement bloqué si on applique, entre sa grille 733 et sa source 731, une tension strictement supérieure à la tension de seuil VTH.

Le deuxième transistor 75 est théoriquement passant si on applique, entre sa grille 753 et sa source 751, une tension supérieure ou égale à la tension VTH. Le deuxième transistor 75 est théoriquement bloqué si on applique, entre sa grille 753 et sa source 751, une tension strictement inférieure à la tension de seuil VTH.

Le troisième transistor 77 est théoriquement passant si on applique, entre sa grille 773 et sa source 771, une tension supérieure ou égale à la tension VTH. Le deuxième transistor 77 est théoriquement bloqué si on applique, entre sa grille 773 et sa source 771, une tension strictement inférieure à la tension de seuil VTH.

On a vu précédemment que la source 731 du premier transistor 73 est connectée au plot 15 de la puce 1. La source 731 du premier transistor 73 est donc mise au potentiel VPAD. La grille 773 du troisième transistor 77 est connectée à la borne 17 de la puce 1. La grille 773 du troisième transistor 77 est donc commandée par le signal numérique CMD.

On suppose qu'un état haut (CMD = 1) du signal CMD est codé par l'application, sur la borne 17, d'une tension supérieure ou égale à VTH. Le troisième transistor 77 est ainsi passant lorsque le signal CMD est à l'état haut.

On suppose aussi qu'un état bas (CMD = 0) du signal CMD est codé par l'application, sur la borne 17, d'une tension strictement inférieure à VTH. Le troisième transistor 77 est ainsi bloqué lorsque le signal CMD est à l'état bas.

Plusieurs cas de fonctionnement de la diode commutable 71 peuvent alors se présenter, en fonction des valeurs respectivement prises par les potentiels VDD et VPAD ainsi que par le signal numérique CMD. Ces différents cas de fonctionnement sont listés dans le tableau ci-dessous.

**[Table 1]**

| Cas | VDD | VPAD | CMD | Transistor 73 | Transistor 75 | Transistor 77 |
|---|---|---|---|---|---|---|
| 1 | ≤ VTH | < VDD + VTH | 0 | bloqué | bloqué | bloqué |
| 2 | ≤ VTH | ≥ VDD + VTH | 0 | passant | bloqué | bloqué |
| 3 | > VTH | < VDD + VTH | 0 | bloqué | passant | bloqué |
| 4 | > VTH | ≥ VDD + VTH | 0 | passant | passant | bloqué |
| 5 | > VTH | < VDD + VTH | 1 | bloqué | passant | passant |
| 6 | > VTH | ≥ VDD + VTH | 1 | passant | passant | passant |

Un courant ne peut théoriquement circuler, entre la borne 15 et la masse GND de la puce 1, que si tous les transistors 73, 75 et 77 de la diode commutable 71 sont passants. D'après le tableau ci-dessus, on voit que la diode commutable 71 est passante seulement dans le cas 6. La diode commutable 71 est donc passante si la tension VPAD est supérieure ou égale à VDD + VTH, si le signal CMD est à l'état haut et si la tension VDD est supérieure à la tension de seuil VTH.

Lorsque le signal CMD est à l'état haut (cas 5 et cas 6), la diode commutable 71 se comporte ainsi comme une diode caractérisée par une tension de seuil égale à VTH. Lorsque le signal CMD est à l'état bas (cas 1 à 4), la diode commutable 71 se comporte, en revanche, comme un circuit ouvert.

La diode commutable 71 se distingue de la diode 331 (figure 2) en ce qu'elle interdit toute injection de courant vers l'alimentation VDD lorsque la puce 1 est hors tension (c'est-à-dire lorsque l'alimentation de la puce 1 est coupée, VDD = 0).

En supposant que la tension VDD est nulle, c'est-à-dire que l'on souhaite maintenir la puce 1 arrêtée ou hors tension, l'application d'une tension à un plot 15 associé à une diode 331 (comme exposé en relation avec la figure 2) peut provoquer une injection de courant vers l'alimentation VDD. Cela risque d'empêcher la mise hors tension ou l'arrêt de la puce 1. En revanche, l'application d'une tension à un plot 15 associé à une diode commutable 71 ne peut pas provoquer d'injection de courant vers l'alimentation VDD. La puce 1 est donc maintenue hors tension ou à l'arrêt.

La diode commutable 71 présente, par conséquent, l'avantage d'empêcher de réalimenter de façon involontaire, par l'application d'une tension sur le plot 15, la puce 1 que l'on souhaite maintenir hors tension.

Divers modes de réalisation et variantes ont été décrits.

Enfin, la mise en oeuvre pratique des modes de réalisation et variantes décrits est à la portée de l'homme du métier à partir des indications fonctionnelles données ci-dessus.

## Revendications

1. Circuit d'entrée-sortie (7) d'une puce électronique (1), comprenant un dispositif comprenant :
- une borne (11) d'entrée d'un coeur (2) de la puce ;
- une borne (13) de sortie du coeur de la puce ;
- un circuit de mise à niveau (31) comprenant un premier circuit tampon (311), dont une sortie (3111) est connectée à la borne d'entrée, et un deuxième circuit tampon (313), dont une entrée (3133) est connectée à la borne de sortie, une entrée (3113) du premier circuit tampon et une sortie (3131) du deuxième circuit tampon étant interconnectées par l'intermédiaire d'un noeud (315) de connexion commun connecté à un plot (15) de connexion de la puce ; et
- un circuit de protection comportant, en série (71) :
un premier transistor (73) MOS de type P, dont la source (731) est connectée au plot (15) ;
un deuxième transistor (75) MOS de type N, connecté au premier transistor ; et
un troisième transistor (77) MOS de type N, connecté au deuxième transistor, le troisième transistor étant commandé par un signal numérique (CMD) appliqué sur une borne (17) de la puce,
dans lequel la grille (733) du premier transistor et la grille (753) du deuxième transistor sont interconnectées et destinées à recevoir un potentiel (VDD) d'alimentation de la puce électronique.

2. Circuit selon la revendication 1, dans lequel :
- le drain (755) du deuxième transistor (75) est connecté au drain (735) du premier transistor (73) ; et
- la source (751) du deuxième transistor (75) est connectée au drain (775) du troisième transistor (77).

3. Circuit selon la revendication 1 ou 2, dans lequel un potentiel (GND) de référence est appliqué sur la source (771) du troisième transistor (77).

4. Circuit selon l'une quelconque des revendications 1 à 3, dans lequel le potentiel (VDD) d'alimentation correspond à une tension continue appliquée entre les grilles (733, 753) communes des premier et deuxième transistors (73, 75) et la source (771) du troisième transistor (77).

5. Circuit selon l'une quelconque des revendications 1 à 4, dans lequel le signal numérique (CMD) est adapté à commander, en tout ou rien, le passage d'un courant dans l'association en série (71).

6. Circuit selon l'une quelconque des revendications 1 à 5, dans lequel l'association en série (71) forme, en fonction de l'état du signal numérique (CMD) commandant le troisième transistor (77), tantôt une diode et tantôt un circuit ouvert.

7. Circuit selon l'une quelconque des revendications 1 à 6, comportant en outre :
- une diode (333), dont l'anode (3331) est connectée à un noeud d'application d'un potentiel de référence (GND) et dont la cathode (3333) est connectée à la source (731) du premier transistor (73) ; et
- un composant de protection (51) contre des surtensions transitoires, connecté en parallèle de la diode.

8. Puce électronique (1) comportant au moins un circuit (7) selon l'une quelconque des revendications 1 à 7.

9. Procédé de commande d'un circuit selon l'une quelconque des revendications 1 à 7, dans lequel :
- le signal numérique (CMD) de commande est placé dans un premier état pour conférer une fonction de diode ; et
- le signal numérique (CMD) de commande est placé dans un deuxième état pour forcer un circuit ouvert.

## Patentansprüche

1. Eingangs-Ausgangsschaltung (7) eines elektronischen Chips (1) mit einer Vorrichtung, die Folgendes aufweist:
- einen Eingangsanschluss (11) eines Kerns (2) des Chips;
- einen Ausgangsanschluss (13) des Kerns des Chips;
- eine Ausgleichsschaltung (31) aufweisend eine erste Pufferschaltung (311), mit einem Ausgang (3111), der mit dem Eingangsanschluss verbunden ist, und eine zweite Pufferschaltung (313), mit einem Eingang (3133), der mit dem Ausgangsanschluss verbunden ist, wobei ein Eingang (3113) der ersten Pufferschaltung und ein Ausgang (3131) der zweiten Pufferschaltung über einen gemeinsamen Verbindungsknoten (315) miteinander verbunden sind, der mit einem Verbindungskontakt (15) des Chips verbunden ist; und
- eine Schutzschaltung, die in Reihe (71) Folgendes aufweist:
einen ersten P-Typ-MOS-Transistor (73), dessen Source (731) mit dem Kontakt (15) verbunden ist;
einen zweiten N-Typ-MOS-Transistor (75), der mit dem ersten Transistor verbunden ist; und
einen dritten N-Typ-MOS-Transistor (77), der mit dem zweiten Transistor verbunden ist, wobei der dritte Transistor (77) durch ein digitales Signal (CMD) gesteuert wird, das an einen Anschluss (17) des Chips angelegt wird,
wobei das Gate (733) des ersten Transistors und das Gate (753) des zweiten Transistors miteinander verbunden sind und dazu bestimmt sind, eine Versorgungsspannung (VDD) des elektronischen Chips zu empfangen.

2. Schaltung nach Anspruch 1, wobei:
- der Drain (755) des zweiten Transistors (75) mit dem Drain (735) des ersten Transistors (73) verbunden ist; und
- die Source (751) des zweiten Transistors (75) mit dem Drain (775) des dritten Transistors (77) verbunden ist.

3. Schaltung nach Anspruch 1 oder 2, wobei an die Source (771) des dritten Transistors (77) ein Referenzspannung (GND) angelegt ist.

4. Schaltung nach einem der Ansprüche 1 bis 3, wobei die Versorgungsspannung (VDD) einer Gleichspannung entspricht, die zwischen den gemeinsamen Gates (733, 753) des ersten und zweiten Transistors (73, 75) und der Source (771) des dritten Transistors (77) angelegt ist.

5. Schaltung nach einem der Ansprüche 1 bis 4, bei der das digitale Signal (CMD) geeignet ist, den Durchgang eines Stroms in der Reihenschaltung (71) in einer EIN-/-AUS Weise zu steuern.

6. Schaltung nach einem der Ansprüche 1 bis 5, bei der die Reihenschaltung (71) in Abhängigkeit vom Zustand des digitalen Signals (CMD), das den dritten Transistor (77) steuert, manchmal eine Diode und manchmal einen offenen Stromkreis abbildet.

7. Schaltung nach einem der Ansprüche 1 bis 6, wobei die Schaltung ferner Folgendes aufweist:
- eine Diode (333) mit einer Anode (3331), die mit einem Knoten verbunden ist, an den eine Referenzspannung (GND) angelegt ist, und einer Kathode (3333), die mit der Source (731) des ersten Transistors (73) verbunden ist; und
- ein Schutzbauteil (51) gegen vorübergehende Überspannungen, das parallel zu der Diode geschaltet ist.

8. Elektronischer Chip (1) mit mindestens einer Schaltung (7) nach einem der Ansprüche 1 bis 7.

9. Verfahren zur Steuerung einer Schaltung nach einem der Ansprüche 1 bis 7, wobei:
- das digitale Steuersignal (CMD) in einen ersten Zustand versetzt wird, um eine Diodenfunktion zu bewirken; und
- das digitale Steuersignal (CMD) in einen zweiten Zustand versetzt wird, um einen offenen Stromkreis zu erzwingen.

## Claims

1. An input-output circuit (7) of an electronic chip (1), comprising a device comprising:
- an input terminal (11) of a core (2) of the chip;
- an output terminal (13) of the core of the chip;
- a levelling circuit (31) comprising a first buffer circuit (311), an output (3111) of which is connected to the input terminal, and a second buffer circuit (313), an input (3133) of which is connected to the output terminal, an input (3113) of the first buffer circuit and an output (3131) of the second buffer circuit being interconnected through a common connection node (315) connected to a connection pad (15) of the chip; and
- a protective circuit comprising, in series (71) :
a first P-type MOS transistor (73), a source (731) of which is connected to the pad (15);
a second N-type MOS transistor (75), connected to the first transistor; and
a third N-type MOS transistor (77), connected to the second transistor, said third transistor (77) being controlled by a digital signal (CMD) applied to a terminal (17) of the chip,
wherein the gate (733) of the first transistor and the gate (753) of the second transistor are interconnected and intended to receive a supply potential (VDD) of the electronic chip.

2. The circuit according to claim 1, wherein:
- the drain (755) of the second transistor (75) is connected to the drain (735) of the first transistor (73); and
- the source (751) of the second transistor (75) is connected to the drain (775) of the third transistor (77) .

3. The circuit according to claim 1 or 2, wherein a reference potential (GND) is applied on the source (771) of the third transistor (77).

4. The circuit according to any of claims 1 to 3, wherein the supply voltage (VDD) corresponds to a DC voltage applied between the common gates (733, 753) of the first and second transistors (73, 75) and the source (771) of the third transistor (77).

5. The circuit according to any of claims 1 to 4, wherein the digital signal (CMD) is adapted to control, in an ON/OFF manner, the passage of a current in the association in series (71).

6. The circuit according to any of claims 1 to 5, wherein the association in series (71) forms, as a function of the state of the digital signal (CMD) controlling the third transistor (77), sometimes a diode and sometimes an open circuit.

7. The circuit according to any of claims 1 to 6, further comprising:
- a diode (333), having an anode (3331) connected to a node to which is applied a reference potential (GND) and a cathode (3333) connected to the source (731) of the first transistor (73); and
- a protective component (51) against temporary overvoltages, connected in parallel to the diode.

8. An electronic chip (1) comprising at least one circuit (7) according to any of claims 1 to 7.

9. A method for controlling a circuit according to any of claims 1 to 7, wherein:
- the digital control signal (CMD) is placed in a first state for imparting a diode function; and
- the digital control signal (CMD) is placed in a second state for forcing an open circuit.
